(19) Europäisches Patentamt
European Patent Office
Office européen des brevets

(11) **EP 2 396 358 B1**

(12) **EUROPÄISCHE PATENTSCHRIFT**

(45) Veröffentlichungstag und Bekanntmachung des Hinweises auf die Patenterteilung:
**23.01.2013 Patentblatt 2013/04**

(21) Anmeldenummer: **10702439.0**

(22) Anmeldetag: **30.01.2010**

(51) Int Cl.:
*C08G 18/81* (2006.01)     *C08L 75/16* (2006.01)
*G03F 7/027* (2006.01)     *G03H 1/02* (2006.01)
*G11B 7/245* (2006.01)     *G11B 7/24* (2013.01)
*C08G 18/10* (2006.01)     *C08G 18/48* (2006.01)
*C08G 18/67* (2006.01)     *C08G 18/77* (2006.01)
*C08G 18/78* (2006.01)     *C08J 7/04* (2006.01)
*C09D 175/08* (2006.01)     *G03F 7/00* (2006.01)
*G03F 7/035* (2006.01)     *G11B 7/253* (2013.01)
*B32B 27/00* (2006.01)

(86) Internationale Anmeldenummer:
**PCT/EP2010/000565**

(87) Internationale Veröffentlichungsnummer:
**WO 2010/091795 (19.08.2010 Gazette 2010/33)**

(54) **METHODE ZUR HERSTELLUNG VON HOLOGRAFISCHEN PHOTOPOLYMEREN AUF POLYMERFOLIEN**

METHOD FOR PRODUCING HOLOGRAPHIC PHOTOPOLYMERS ON POLYMER FILMS

PROCÉDÉ DE PRODUCTION DE PHOTOPOLYMÈRES HOLOGRAPHIQUES SUR DES FILMS POLYMÈRES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **12.02.2009 EP 09001952**

(43) Veröffentlichungstag der Anmeldung:
**21.12.2011 Patentblatt 2011/51**

(73) Patentinhaber: **Bayer MaterialScience AG**
**51368 Leverkusen (DE)**

(72) Erfinder:
• **HÖNEL, Dennis**
**53909 Zülpich (DE)**
• **WEISER, Marc-Stephan**
**51379 Leverkusen (DE)**
• **BRUDER, Friedrich-Karl**
**47802 Krefeld (DE)**
• **RÖLLE, Thomas**
**51381 Leverkusen (DE)**
• **FÄCKE, Thomas**
**51375 Leverkusen (DE)**

(56) Entgegenhaltungen:
WO-A-2008/125199     DE-A1- 19 754 024
JP-A- 2001 187 362

**Beschreibung**

Die Erfindung betrifft eine Methode zur Herstellung neuartiger Photopolymere basierend auf prepolymerbasierten Polyurethanzusammensetzungen, die sich für die Herstellung holographischer Medien, insbesondere zur visuellen Darstellung von Bildern eignen.

Photopolymere stellen Materialien dar, die mittels der Überlagerung zweier kohärenter Lichtquellen belichtet werden können, wobei sich eine dreidimensionale Struktur in den Photopolymeren ausbildet, die sich im allgemeinen durch eine regionale Änderung des Brechungsindexes in dem Material beschreiben lässt. Derartige Strukturen werden Hologramme genannt. Sie können auch als diffraktive optische Elemente beschrieben werden. Dabei hängt es von der speziellen Belichtung ab, welche optischen Funktionen ein solches Hologramm ausbildet.

Polymerformulierungen zur Herstellung von holographischen Medien wurden unter anderem in den nicht vorveröffentlichten Patentanmeldungen EP 08017279.4, EP 08017277.8, EP 08017273.7, EP 08017275.2 beschrieben. In EP 08017277.8 und EP 08017273.7 sind polyetherbasierte und prepolymer-basierte Polyurethanzusammensetzungen beschrieben, die sich zur Herstellung holographischer Medien im Allgemeinen eignen. In EP 08017275.2 wurden Polyurethanformulierungen mit speziellen Acrylaten beschrieben, die zur Aufzeichnung von Hologrammen geeignet sind. Weiterhin wurde in EP 08017279.4 erstmals ein typischer Folienaufbau und die Applikation verschiedener Polyurethanformulierungen als Photopolymer im Folienverbund beschrieben.

Die Herstellung solcher holografischen Medien als Glas- oder Folienverbund erfolgte im Stand der Technik bisher in verfahrenstechnischen Einzelschritten, die sich für eine produktionsähnliche und bedarfsgerechte Herstellung nicht eignen.

Für die produktionsähnliche Herstellung solcher Folienverbunde werden FolienBeschichtungsanlagen, die als kontinuierlich betriebener Rolle-zu-Rolle Prozess zu verstehen sind, eingesetzt. Unter Folienbeschichtung werden im Allgemeinen das Aufbringen einer flüssigen Substanz auf ein sich bewegendes Folienmaterial verstanden. Die Beschichtungsverfahren unterscheiden sich unter anderen nach den Eigenschaften der aufzubringenden Schicht (z.B. Viskosität, Oberflächenspannung, Feststoffkonzentration, u.w.), der aufzubringenden Zielschichtdicke oder der Produktionsgeschwindigkeit.

Die für die Produktion einzusetzenden Folienbeschichtungsanlagen bestehen typischerweise aus:

- Einer Rollenabwicklung, die die Zuführung des Trägermaterials (Foliensubstrat) gewährleistet.

- Vorbehandlung des Beschichtungsmaterials: Für die Vorbehandlung werden Zubehöreinheiten und Peripheriegeräte wie z.B. Dissolver und Knetwerke, Wiegesysteme, verschieden Pumpensysteme, automatische Feststoffzuführungen, Verbrauchsmesssysteme, Filtereinheiten, Entgasungseinrichtungen und Mischsysteme eingesetzt.

- Vorbehandlung des Trägermaterials: Als Vorbehandlungseinheiten werden in der Beschichtungsindustrie Bahnreinigungssysteme für die Trägermaterialreinigung, dem Fachmann bekannte Ionisierungseinheiten zum Homogenisieren der auf dem Trägermaterial befindlichen elektrischen Ladungen, Plasma- oder Coronabehandlungen eingesetzt. Des Weiteren werden Bahnsteuerungssysteme eingesetzt, die durch Einrichtungen wie z.B. Bahnkantensteuerung und Bahnspeichersysteme unterstützt werden.

- Auftragssystem für die Applikation eines Beschichtungsmaterials: Als Auftragsysteme kommen in der Beschichtungsindustrie diverse Rakel- und Streichsysteme, Schlitzgießer und Rollenantragssysteme, wie auch für den mehrschichtigen Antrag Systeme wie z.B. Vorhang- oder Kaskadenverfahren zum Einsatz.

Einsetzbare Beschichtungseinrichtungen wie z.B. Vorhang- oder Kaskadenbeschichter oder Schlitzdüsen werden in früheren Veröffentlichungen z.B. (P. M. Schweizer, "Vordosierte Beschichtungsverfahren: Vorzüge und Anwendungen", Coating, Ausgabe 12/1998, Seite 462 - 465) beschrieben: So beschreibt Schweizer vordosierende Beschichtungsverfahren, die bereits in den fünfziger Jahren unter anderem in der Fotoindustrie entwickelt wurden. Bei diesen Verfahren erfolgt die Flüssigkeitsverteilung in Querrichtung zum Trägermaterial durch eine homogene Druckverteilung innerhalb einer Düse. Diese Verfahren werden für einschichtige, wie auch für mehrschichtige Produkte eingesetzt (Schlitzdüse ≤ 3, Kaskaden- und Vorhangverfahren > 10). Beim Schlitz- und Kaskadenverfahren ist die Düse nur durch einen sehr engen Spalt vom Trägermaterial getrennt. Beim Vorhangverfahren befindet sich die Düse mehrere Zentimeter vom Trägermaterial entfernt, so dass die Flüssigkeitsverteilung vom Beschichtungsprozess weitgehend entkoppelt ist.

Des weiteren werden alle gängigen Walzenantragssysteme, die sich im Speziellen durch die Anordnung, Ausführungen und der Anzahl der Walzen unterscheiden, eingesetzt. Dabei kann das aufzutragende Beschichtungsmaterial entweder in einer Wanne oder im Spalt zwischen zwei horizontal angeordneter Walzen zur Dosierung aufbewahrt werden. In allen Fällen beeinflusst die Drehzahl der benetzten Walzen, die Beschaffung (Rasterung, Glattwalzen) der Walzen, Viskosität und Oberflächenspannung die anzutragende Schichtdicke im Verhältnis zur Substratgeschwindigkeit.

Zusätzlich werden bei steigenden Substratgeschwindigkeiten weitere Walzen eingesetzt, die durch unterschiedlich angepassten Drehzahlen der Walzen und eines definierten Spaltabstands zwischen zwei Walzen eine weitere Verstreckung des Beschichtungsmaterials hervorrufen. Die letzte Walze in dem System steht in einem sehr engen Abstand zum Trägermaterial und somit wird das Beschichtungsmaterial entweder im Gegenlauf oder im Gleichlauf an das Trägermaterial angepresst. Drehzahl der Walze, Spaltabstand, Geschwindigkeit des Trägermaterials und die Viskosität sind entscheidende Faktoren bei der Einstellung der gewünschten Nassschichtdicken.

Ein 5- bzw. 6- Walzenantragssystem wird z.B. von der Firma Maschinenfabrik Max Kroenert GmbH & Co. KG (M. Schmalz, N. Hansen, W. Neumann, "5- oder 6-Walzen Beschichtungsverfahren", Coating, Ausgabe 10/2006, Seite 410-413) beschrieben. Die Autoren vergleichen in dieser Veröffentlichung die Vor- und Nachteile eines 5- zu einem 6-Walzenantragsystem anhand einer lösungsmittelfreien Silikonbeschichtung mit thermisch und UV härtbaren Silikonen.

- Trocknereinheiten: Zum Trocknen des Beschichtungsmaterials auf dem Trägermaterial werden unter anderem Heißlufttrockner mit vortemperierter Luft, IR-Strahler oder UV-Geräte eingesetzt. Zur Nachbehandlung der beschichteten Trägermaterialien kommen Kühlwalzen, Breitstreckwalzen, Kaschierwerke, Kalanderwalzen, Schneideeinrichtung (wie z.B. Kantenschneider) zum Einsatz. Zusätzlich können die genannten Prozesse auch für lösungsmittelhaltige Systeme zum Einsatz kommen und werden somit als eine explosionsschützenden Einheit ausgerüstet.

- Aufwickeleinrichtung zum Wickeln des beschichteten Produkts bzw. Trägerfolie.

- Die genannten Prozessschritte werden in der Beschichtungsindustrie zusätzlich mit Systemen für die Qualitätssicherung, wie z.B. Schichtdickenmessungen, optischen Oberflächenkontrollsystemen, Luftfeuchte- oder Lösungsmittelkonzentrationsmessungen und Produktrestfeuchtemessungen ergänzt.

Aufgabe der vorliegenden Erfindung war es nun, ein großtechnisches Verfahren bereitzustellen, mit dem holografische Photopolymerfolien, ausgehend von prepolymer-basierten Polyurethanformulierungen in kontinuierlicher Herstellweise produziert werden können. Das Produkt soll dabei ein Folienverbund aus Begussfolie, Photopolymer und einer Deckfolie sein.

Gelöst wurde diese Aufgabe durch die spezielle Kombination verschiedener Prozessschritte bei denen dem Fachmann bekannte Zwangsdosierpumpen, Vakuumentgaser, Plattenfilter, Statische Mischer, Schlitzdüsen oder verschiedene Rakelsysteme, Ein-Rollenabwickler, Lufttrockner, Trockenkaschiereinrichtung und eine Ein-Rollenaufwickeleinrichtung, eingesetzt werden. Speziell die Beschichtungseinrichtung, wie z.B. Schlitzdüsen und Rakelsysteme, sind für die Applikation von flüssigen Beschichtungsmaterialien, speziell in Verbindung mit Photopolymerformulierungen, bevorzugt prepolymer-basierte Polyurethanformulierungen nachstehender Zusammensetzungen, auf bewegende Trägermaterialien geeignet und zeichnen sich durch eine hohe Genauigkeit in der Applikationsschichtdicke aus.

Gegenstand der vorliegenden Erfindung ist ein kontinuierliches Verfahren zur Herstellung von Photopolymerfolien, bei dem eine Trägerfolie nach dem Rolle-zu-Rolle-Prinzip mit einer Photopolymerformulierung umfassend

A) eine Polyisocyanatkomponente, wenigstens enthaltend ein NCO-terminiertes Polyurethanprepolymer dessen NCO-Gruppen primär aliphatisch gebunden sind und welches auf hydroxyfunktionellen Verbindungen mit einer OH-Funktionalität von 1,6 bis 2,05 basiert,

B) Isocyanat-reaktive Polyetherpolyole

C) Urethanacrylate und/oder Urethanmethacrylate mit mindestens einer aromatischen Struktureinheit und einem Brechungsindex von größer 1,50 bei 405 nm, die selbst frei von NCO-Gruppen und OH-Gruppen sind

D) Radikalstabilisatoren

E) Photoinitiatoren auf Basis von Kombinationen aus Boratsalzen und einem oder mehreren Farbstoffen mit Absorptionsbanden, die zumindest teilweise den Spektralbereich von 400 bis 800 nm abdecken

F) Gegebenenfalls Katalysatoren

G) Gegebenenfalls Hilfs- und Zusatzstoffe

beschichtet wird.

Weitere Gegenstände der Erfindung sind nach dem erfindungsgemäßen Verfahren erhältliche Photopolymerfolien, die geeignet sind zur Aufzeichnung visueller Hologramme und deren weitere Verwendung als optische Elemente, Bilder oder zur Bilddarstellung oder -projektion.

In Komponente A) werden Prepolymere eingesetzt, die dem Fachmann in an sich gut bekannter Art und Weise durch Umsetzung von monomeren, oligomeren oder Polyisocyanaten A1) mit isocyanatreaktiven Verbindungen A2) in geeigneter Stöchiometrie unter optionalem Einsatz von Katalysatoren und Lösemitteln erhalten werden können. Bevorzugte Prepolymere sind Urethane oder Allophanate aus aliphatischen Isocyanat-funktionellen Verbindungen und oligomeren oder polymeren Isocyanat-reaktiven Verbindungen, wobei die Prepolymere zahlenmittlere Molmassen von 200 bis 10000 g/Mol und NCO-Funktionalitäten von 1,9 bis 5,0 aufweisen. Besonders bevorzugt sind difunktionelle Urethane und Allophanate mit Funktionalitäten von größer 1,9 bis 3,2 oder von 3,9 bis 4,2.mit zahlenmittleren Molmassen von 650 bis 8200 g/Mol hergestellt aus aliphatischen Isocyanat-funktionellen Verbindungen und oligomeren oder polymeren Polyolen oder deren beliebige Mischungen. Ganz besonders bevorzugt sind Urethane mit NCO-Funktionalitäten von 1,9 bis 2,1 und zahlenmittleren Molmassen von 1900 bis 4100 g/Mol, hergestellt aus aliphatischen Isocyanat-funktionellen Verbindungen und oligomeren oder polymeren Polyolen und Allophanate mit Funktionalitäten von größer 2,0 bis 3,2 oder von 3,9 bis 4,2 mit zahlenmittleren Molmassen von 1900 bis 4100 g/Mol, hergestellt aus aliphatischen Isocyanat-funktionellen Verbindungen und oligomeren oder polymeren Polyolen oder deren beliebige Mischungen.

Als Komponente B) werden isocyanat-reaktive Polyetherpolyole eingesetzt, die bevorzugt im Mittel wenigstens 1,5 isocyanatreaktive-Gruppen pro Molekül aufweisen. Bevorzugte Verbindungen der Komponente B) sind Poly(propylenoxid)e, Poly(ethylenoxide) und deren Kombinationen in Form von statistischen oder Blockcopolymeren sowie Blockcopolymere aus Propylenoxid und/oder Ethylenoxid. Dabei ist der Ethylenoxidanteil bezogen auf Gewichtsprozent des gesamten Produktes bevorzugt kleiner als 55%, besonders bevorzugt entweder zwischen 55% und 45% oder kleiner als 30% und ganz besonders bevorzugt kleiner als 10%. Als ganz besonders bevorzugte Verbindungen der Komponente B) sind difunktionelle Polyetherpolyole, basierend auf Propylenoxid und Ethylenoxid mit einem Ethylenoxidanteil von kleiner 10 Gewichtsprozent bezogen auf die Gesamtmasse des zugrundeliegenden Polyethers, und einer zahlenmittleren Molmasse zwischen 2000 und 4200 g/mol eingesetzt. Die Komponenten A) und B) werden bei der Herstellung der Photopolymerformulierung in einem OH/NCO-Verhältnis zueinander eingesetzt von typischerweise 0,9 bis 1,2, bevorzugt 0,95 bis 1,05.

In Komponente C) werden bevorzugt Urethanacrylate und/oder Urethanmethacrylate mit mindestens einer aromatischen Struktureinheit und einem Brechungsindex von größer 1,50 bei 405 nm eingesetzt. Unter Urethan(meth) acrylaten versteht man Verbindungen mit mindestens einer Acrylat- bzw. Methacrylatgruppe, die zusätzlich über mindestens eine Urethanbindung verfügen. Besonders bevorzugte als Komponente C) zu verwendende Verbindungen sind Urethanacrylate und Urethanmethacrylate auf Basis aromatischer Isocyanate und 2-Hydroxyethylacrylat, Hydroxypropylacrylat, 4-Hydroxybutylacrylat, Polyethylenoxid-mono(meth)acrylat, Polypropylenoxid-mono(meth)acrylat, Polyalkylenoxidmono(meth)acrylat und Poly($\in$-caprolacton)mono(meth)-acrylate. In einer ganz besonders bevorzugten Ausführungsform werden als Komponente C) die Additionsprodukte aromatischer Triisocyanate (ganz besonders bevorzugt Tris-(4-phenylisocyanato)-thiophosphat oder Trimere aromatischer Diisocyanate wie Toluylendiisocyanat) mit Hydroxyethylacrylat, Hydroxypropylacrylat, 4-Hydroxybutylacrylat eingesetzt. In einer weiteren ganz besonders bevorzugten Ausführungsform werden als Komponente C Additionsprodukte von 3-Thiomethyl-phenylisocyanat mit Hydroxyethylacrylat, Hydroxypropylacrylat, 4-Hydroxybutylacrylat eingesetzt.

Als Verbindungen der Komponente D) geeignet sind Inhibitoren und Antioxidantien. Bevorzugt sind 2,6-Di-*tert.*-butyl-4-methylphenol, Phenothiazin, p-Methoxyphenol, 2-Methoxy-p-hydrochinon und Benzhydrol.

Als Komponente E) werden ein oder mehrere Photoinitiatoren eingesetzt. Bevorzugte Photoinitiatoren E) sind Mischungen aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat (Komponente E1)) mit Farbstoffen wie beispielsweise Astrazon Orange G, Methylenblau, Neu Methylenblau, Azur A, Pyrillium I, Safranin O, Cyanin, Gallocyanin, Brilliant Grün, Kristallviolett, Ethylviolett und Thionin (Komponente E2)). Insbesondere bevorzugt ist die Kombination von je einem blau-sensitiven, einem grün-sensitiven sowie einem rot-sensitiven Farbstoff (z.B. Astrazon Orange G, Ethylviolett und Neu Methylenblau) und einem der vorgenannten Boratsalze.

Als Verbindungen der Komponente F) können gegebenenfalls ein oder mehrere Katalysatoren eingesetzt werden. Bevorzugt sind Dibutylzinndilaurat, Dimethylbis[(1-oxoneodecyl)oxy]stannan, Dimethylzinndicarboxylat, 1,4-Diazabicyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Selbstverständlich können gegebenenfalls weitere Zusatzstoffe G) eingesetzt werden. Dabei kann es sich beispielsweise um im Bereich der Lacktechnologie gängige Zusatzstoffe wie Lösemittel, Weichmacher, Verlaufsmittel, Entschäumungsmittel oder Haftvermittler handeln. Als Weichmacher werden dabei bevorzugt Flüssigkeiten mit guten Löseeigenschaften, geringer Flüchtigkeit und hoher Siedetemperatur eingesetzt. Als Verlaufsmittel können oberflächenaktive Verbindungen wie z.B. Polydimethylsiloxane verwendet werden. Es kann auch von Vorteil sein, gleichzeitig mehrere Zusatzstoffe eines Typs zu verwenden. Selbstverständlich kann es ebenfalls von Vorteil sein, mehrere Zusatzstoffe mehrerer Typen zu verwenden.

Besonders bevorzugt umfassen die beschriebenen Photopolymerformulierungen:

18 bis 30 Gew.-% Komponente A)

35 bis 57,37 Gew.-% der Komponente B)

20 bis 35 Gew.-% der Komponente C)

0,02 bis 0,1 Gew.-% Radikalstabilisatoren D)

1 bis 1,5 Gew.-% Photoinitiatoren E1)

jeweils 0,03 bis 0,1 Gew.-% der drei Farbstoffe E2), die im Absorptionsspektrum auf die Laserwellenlängen rot, grün und blau abgestimmt sind

0,02 bis 0,1 Gew.-% Katalysatoren F)

3,5 bis 5 Gew.-% Hilfs- und Zusatzstoffe G).

In einer bevorzugten Ausführungsform umfasst der Beschichtungsprozess der Trägerfolie die nachfolgenden Einzelschritte zur Behandlung vorgenannten Photopolymerverbindungen:

I. Fördern und Dosieren zum einen der Komponente A) gegebenenfalls gemischt mit einer oder mehrerer der Komponenten E), F) und G) sowie zum anderen separat dazu der Komponente B) gegebenenfalls gemischt mit einer oder mehrerer der Komponenten C), D), E), F) und G)

II. Entgasen der gemäß I) geförderten, dosierten und gegebenenfalls vorvermischten Ströme

III. Filtrieren der nach II) erhaltenen Mischung

IV. Homogenisieren der nach III) erhaltenen Mischung

V. Abwicklung und Vorbehandlung des Trägermaterials

VI. Beschichten des Trägermaterials mit der nach Schritt IV) erhaltenen Mischung

VII. Trocknung des nach VI) beschichteten Films

VIII. Kaschieren des nach VII) erhaltenen beschichteten Films

IX. Aufwicklung des nach VIII) erhaltenen kaschierten Films

Für die Förderung und die benötigte Genauigkeit beim Dosieren (I) eignen sich alle dem Fachmann bekannten Pumpensysteme, die im Speziellen gegendruckunabhängig, pulsationsarm und präzise fördern. Bevorzugt werden demnach Membranpumpe, Zahnradpumpen, Excenterschneckenpumpen (Mohnopumpen), Schlauchpumpen und Kolbenpumpen. Besonders bevorzugt sind Zahnradpumpen und Excenterschneckenpumpen (Mohnopumpen).

Bevorzugte Dosiermengen sind abhängig von der Dimensionierung der zu beschichtenden Trägerfolie, liegen aber üblicherweise im Bereich von 2 ml/min bis 2.000 ml/min, besonders bevorzugt im Bereich von 2 ml/min bis 500 ml/min.

Falls notwendig kann auch eine Entgasung (II) der einzelnen Komponenten oder der gesamten Mischung unter einem reduzierten Druck von beispielsweise 1 mbar durchgeführt werden. Ein Entgasen, insbesondere nach Zugabe der Komponente A) ist bevorzugt, um Blasenbildung durch Restgase oder leicht verdampfbare Komponenten in den hergestellten Photopolymeren zu verhindern.

Beim Entgasen werden gelöste Gase oder leicht verdampfbare Komponenten wie leicht-flüchtige Lösungsmittel (z.B. durch eingetragene Umgebungsluft) aus den Fluiden entfernt und gegebenenfalls kann das zu entgasende Fluid zusätzlich untersättigt werden. Als technische Entgaser können unter anderem Vakuumentgaser, Membranentgaser, Zentrifugalentgaser, Ultraschallentgaser und Dünnschichtentgaser und Kombinationen der genannten Technologien eingesetzt werden.

Die Filtration (III) dient zur Abtrennung von Feststoffpartikeln aus dem flüssigen Medium und wird speziell als Reinigungsschritt für die flüssigen Komponenten eingesetzt. In der Beschichtungsindustrie werden in der Regel Kerzenfilter und Plattenfilter eingesetzt. Bevorzugte Partikelgrößenverteilungen liegen zwischen 0,1 µm bis 5 µm, besonderes bevorzugte Partikelgrößenverteilungen liegen im Bereich von 0,2 µm und 1 µm.

Zur Vermischung (IV) können alle dem Fachmann aus der Mischungstechnik an sich bekannten Verfahren und Apparate, wie beispielsweise Rührkessel oder sowohl dynamische als auch statische Mischer verwendet werden. Bevorzugt sind allerdings Apparate ohne oder mit nur geringen Toträumen. Weiterhin sind Verfahren bevorzugt, in denen die Vermischung innerhalb sehr kurzer Zeit und mit sehr starker Durchmischung der beiden zu mischenden Komponenten erfolgt. Hierfür eignen sich insbesondere dynamische Mischer, insbesondere solche, in denen die Komponenten erst im Mischer miteinander in Kontakt kommen.

Die Temperaturen betragen dabei 0 bis 100 °C, bevorzugt 10 bis 80 °C, besonders bevorzugt 20 bis 60 °C.

Vor Zumischung der Komponente A) können die Mischungen der Komponenten B) bis G) als lagerstabiles Zwischenprodukt gegebenenfalls über mehrere Monate gelagert werden kann.

Nach der Zumischung der Komponente A) der erfindungsgemäßen Polyurethanzusammensetzungen wird eine klare, flüssige Formulierung erhalten, die je nach Zusammensetzung bei Raumtemperatur innerhalb weniger Sekunden bis zu einigen Stunden aushärtet.

Das Verhältnis sowie die Art und Reaktivität der Aufbaukomponenten der Polyurethanzusammensetzungen wird bevorzugt so eingestellt, dass die Aushärtung nach Zumischung der Komponente A) bei Raumtemperatur innerhalb von Minuten bis zu einer Stunde eintritt. In einer bevorzugten Ausführungsform wird die Aushärtung beschleunigt indem die Formulierung nach der Zumischung auf Temperaturen zwischen 30 und 180 °C, bevorzugt 40 bis 120 °C, besonders bevorzugt 50 bis 100 °C erwärmt wird.

Die Polyurethanzusammensetzungen besitzen unmittelbar nach vollständiger Vermischung aller Komponenten Viskositäten bei 25°C von typischerweise 10 bis 100000 mPas, bevorzugt 100 bis 20000 mPas, besonders bevorzugt 200 bis 10000 mPas, insbesondere bevorzugt 500 bis 5000 mPas so dass sie bereits in lösemittelfreier Form sehr gute verarbeitungstechnische Eigenschaften besitzen. In Lösung mit geeigneten Lösemitteln können Viskositäten bei 25°C unterhalb 10000 mPas, bevorzugt unterhalb 2000 mPas, besonders bevorzugt unterhalb 500 mPas eingestellt werden.

Als vorteilhaft haben sich Polyurethanzusammensetzungen der vorstehend genannten Art erwiesen, die mit einem Katalysatorgehalt (Komponente F) von 0,004 Gew.-% bis 0,1 Gew.-% bei 80°C unter 6 Minuten aushärten, bevorzugt werden Konzentrationen zwischen 0,01 Gew.-% und 0,08 Gew.-%, besonders bevorzugt werden Konzentrationen zwischen 0,04 Gew.-% und 0,06 Gew.-%.

Die Abwicklung (V) des Trägermaterials erfolgt in diskontinuierlichen Prozessen mit dem Fachmann bekannten Einzelrollenabwicklern. Bei diesen diskontinuierlichen Prozessen wird eine einzelne unbeschichtete Rolle in der Abwicklungsvorrichtung eingesetzt und in kompletter Länge dem Beschichtungsprozess zugeführt. Am Ende der Rolle wird der Beschichtungsprozess unterbrochen und das fertig beschichtete und aufgewickelte Trägermaterial wird an der Aufwickelstation dem Prozess entnommen und produktspezifisch verpackt. An der Abwickelvorrichtung wird eine neue unbeschichtet Rolle eingesetzt und mit dem Ende des voranproduzierten Trägermaterials mit geeigneten Klebefolien befestigt. Nach dem Starten des Maschinenvorzugs des Trägermaterials kann mit dem Beschichtungsprozesses fortgeführt werden.

Bei der kontinuierlichen Beschichtung von Trägermaterialien kommen Mehrrollenabwicklern, die als Wendescheibenabwicklern oder Wendekreuze angeordnet sind, zum Einsatz. Der kritische Übergang von einem diskontinuierlichen Prozess beim Einsetzten einer unbeschichteten Trägermaterialrolle zu einem kontinuierlichen Beschichtungsprozess, ohne diesen Beschichtungsprozess zu unterbrechen, wird entweder mit Hilfe eines Bahnspeichers oder eines dem Fachmann bekannten fliegenden Anklebprozesses durchgeführt.

Ein Bahnspeicher dient als Puffer für die Phase des Stillstands beim Rollenwechsel und Ankleben der Rollenabwicklung. Hierbei wird nach dem Bestücken der Materialabwicklung die Vorzugsgeschwindigkeit schrittweise auf einen Wert oberhalb der eigentlichen optimalen Beschichtungsgeschwindigkeit erhöht. Nach dem Überschreiten der Beschichtungsgeschwindigkeit wird der Bahnspeicher mit Trägermaterial bis zur Vollständigkeit gefüllt. Anschließend wird die Vorzugsgeschwindigkeit auf die eigentliche Beschichtungsgeschwindigkeit angepasst. Parallel wird die zweite Materialabwicklungseinrichtung im Mehrrollenabwickler mit einer weiteren unbeschichteten Rolle bestückt. Am Ende der voranbenutzten Rolle wird die Vorzugsgeschwindigkeit sofort stark reduziert und gestoppt. Dabei wird durch Beibehalten der Beschichtungsgeschwindigkeit der Bahnspeicher kontinuierlich entleert. Parallel wird der Anfang der bereits am zweiten Materialabwickler bestückten Rolle an das Ende der voran eingesetzten Rolle mit entsprechend geeigneten Klebematerialen befestigt. Anschließend wird die Vorzugsgeschwindigkeit wieder gestartet und schrittweise über die Beschichtungsgeschwindigkeit angehoben, um den Bahnspeicher erneut zu füllen. Parallel wird der Mehrrollenabwickler (in Drehscheibenausführung oder als Wendekreuz) um 180° geschwenkt. Während des gesamten Ablaufs der Materialwechsel wird die Beschichtungsgeschwindigkeit über die Prozessteuerung mit Hilfe zusätzlicher Hilfsantriebe konstant gehalten.

Zur Steuerung des Trägermaterials in Querrichtung zur Vorzugsrichtung werden dem Fachmann bekannte Bahnlaufregelungseinheiten eingesetzt. Dabei wird die Position der Bahnkante mit Hilfe von optischen Sensoren, wie z.B. Reflexionssensoren, Transmissionslichtsensoren oder Ultraschallsensoren ermittelt und mit Hilfe von Steuerwalzensystemen, die auf einen angetriebenen Drehrahmen positioniert sind, mechanisch korrigiert.

Bei der Reinigung des Trägermaterials wird zwischen zwei unterschiedlichen Reinigungsverfahren unterschieden: Dem kontaktierenden und der berührungslosen Oberflächenreinigung. Beim kontaktierenden Reinigungsverfahren handelt es sich um Reinigungsbürsten, die mit speziellen weichen Bürstenmaterialien ausgestattet sind. Nachteil dieses Verfahrens ist das Auftreten von Störungen im Trägermaterial, welche durch den Kontakt der Bürste mit dem Trägermaterial entstehen können. Diesbezüglich sind Prozessparameter wie Umdrehungsgeschwindigkeit, Bürstenmaterial, und der Abstand zum Trägermaterial anzupassen.

Berührungslose Verfahren wie z.B. Ionisierungseinheiten, Absaugkanälen oder Luftgebläse sind diesbezüglich materialschützende Verfahren. Diese Ionisierungseinheiten erzeugen positive und negative Ionen, die die Oberflächenladungen auf dem Trägermaterial neutralisieren. Dadurch werden statische Ladungen auf dem Trägermaterial, die dazu führen, Staub und Partikel aus der Umgebung anzuziehen, vermieden. Optional werden die Reinigungssysteme mit zusätzlichen Absaugkanälen ausgestattet, die Partikel von der Oberfläche des Trägermaterials abtransportieren. Unterstützt wird dieses durch den Einsatz einer speziell angeordneten Flachstrahldüse, die mit einem feinen Druckluftstrahl Staub und Partikel von der Oberfläche lösen und wegblasen. Diese Partikel werden ebenfalls über die installierten Absaugkanäle abtransportiert und gefiltert. Die beschriebenen Verfahren zur Bahnreinigung können in beliebiger Reihenfolge und Positionierung angeordnet und kombiniert werden.

Zur Verbesserung der Haftungseigenschaften der Trägermaterialen werden dem Fachmann bekannte Corona- und Plasma-Vorbehandlungssysteme eingesetzt. Das Trägermaterial wird einer elektronischen Hochspannungs-Entladung ausgesetzt, die zwischen einer geerdeten und polierten Stahl- oder Aluminiumwalze und einer eng anliegenden isolierten Elektrode auftritt. Dabei wird nur die zur Elektrode zugewandte Seite behandelt. Gängige Elektroden werden hierbei mit Hochfrequenzgeneratoren mit einer Wechselspannung von 10 bis 20kV und einer Frequenz zwischen 10 und 60 kHz versorgt.

Zur Applikation auf ein Trägermaterial (Beschichten, VI) bzw. in eine Form sind alle jeweiligen gängigen, dem Fachmann bekannten Verfahren geeignet, wie insbesondere Rakeln, Gießen, Drucken, Siebdruck, Spritzen, oder Inkjet-Druck. Bevorzugt sind Rakel und Schlitzdüsen als Folienbeschichtungsverfahren geeignet.

Für die beschriebenen Beschichtungsverfahren werden dem Fachmann bekannte Oberflächenspannungen der beschriebenen Polyurethanzusammensetzungen mit Hilfe der beschriebenen Additive angepasst. Bevorzugte Oberflächenspannungen liegen hierbei zwischen 10 mN/m und 50 mN/m, besonders bevorzugt von 20 mN/m bis 40 mN/m.

Bevorzugte Beschichtungsbreiten liegen zwischen 100 mm und 3000 mm, besonders bevorzugt sind Breiten im Bereich von 300 mm bis 2000 mm.

Substratgeschwindigkeiten liegen bevorzugt im Bereich von 0,2 m/min bis 300 m/min. Besonders bevorzugte Substratgeschwindigkeiten sind im Bereich von 1,0 m/min bis 50 m/min zu finden.

Applizierte Trockenschichtdicken für Rakel und Schlitzdüsen liegen bevorzugt bei höchstens 200 $\mu$m, besonders bevorzugt bei 3 $\mu$m bis 100 $\mu$m, ganz besonders bevorzugt 15 $\mu$m bis 60 $\mu$m.

Die Trocknung (VII) des beschichteten Substrats erfolgt bevorzugt bei einer Temperatur von 30 °C bis 180 °C, besonders bevorzugt von 40 °C bis 120 °C, ganz besonders bevorzugt von 50 °C bis 100 °C.

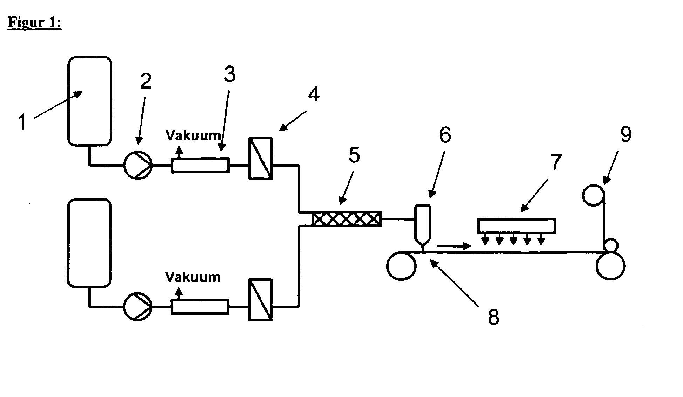

In einer bevorzugten Ausführung erfolgt dabei die Dosierung der Einsatzstoffe entweder durch Zahnrad- oder Excenterschneckenpumpen. Zur Entgasung der Einsatzstoffe werden Zentrifugalentgaser und zur Filterung Plattenfilter eingesetzt. Die Mischung der Einzelkomponenten erfolgt über einen statischen Mischer mit entsprechend ausgelegten Mischgeometrien, wie z.B. Länge und Durchmesser. Als bevorzugte Beschichtungseinheit wird eine Schlitzdüse eingesetzt. Das beschichtete Material wird über Lufttrockner mit der gewünschten Lufttemperatur und Feuchtgehalt über einen definierten Zeitraum getrocknet. Figur 1 zeigt eine Übersicht der beschriebenen Kombination der einzelnen Herstellschritte eines beschichteten Substrats.

Figur 1: Schematischer Aufbau einer typischen Beschichtungsanlage, inklusive Anordnung der Vorbehandlung des Beschichtungsmaterials (1-5), schematischer Verlauf des Trägermaterials (8 + 9), Beschichtungseinrichtung zum Applizieren auf ein Trägermaterial (6) und anschließenden Trocknungsprozess (7).

Bezugszeichen in Figur 1:

1    Vorratsbehälter

2    Dosiereinrichtung

3    Vakuumentgasung

4    Filter

5    Statischer Mischer

6    Beschichtungseinrichtung

7    Trockner

8    Bahnlauf

9    Produkt-Kaschierung

Durch die Kombination der beschriebenen Prozessschritte wie in Figur 1 dargestellt, wird eine höhere Schichtdickengenauigkeit an applizierten Photopolymerschichtdicken auf bewegende Trägermaterialien erzielt.

Ein weiterer Gegenstand der vorliegenden Erfindung ist der Artikel, der durch Beschichtung eines transparenten Substrates mit der beschriebenen präpolymerbasierten Polyurethanformulierung erhalten wird.

Dabei handelt es sich um ein lichtsensitives (Spektraler Wellenlängenbereich 400 bis 800 nm des elektromagnetischen Spektrums) Produkt, welches einen Folienverbund aus mindestens Begussfolie oder Trägermaterial (Substrat) aufweist, der Photopolymerschicht, die aus der beschriebenen Formulierung hergestellt wird sowie einer Deck- oder Kaschierfolie. Im Folienverbund können weitere Folien enthalten sein.

Bevorzugte Materialien oder Materialverbünde der Trägerschicht basieren auf Polycarbonat (PC), Polyethylenterephthalat (PET), Polybutylenterephthalat, Polyethylen, Polypropylen, Celluloseacetat, Cellulosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral oder Polydicyclopentadien oder deren Mischungen. Daneben können Materialverbünde wie Folienlaminate oder Coextrudate als Trägerfolie Anwendung finden. Beispiele für Materialverbünde sind Duplex- und Triplexfolien aufgebaut nach einem der Schemata A/B, A/B/A oder A/B/C wie PC/PET, PET/PC/PET und PC/TPU (TPU = Thermoplastisches Polyurethan). Besonders bevorzugt wird PC und PET als Trägerfolie verwendet.

Bevorzugt sind transparente Träger, die optisch klar, d.h. nicht trüb sind. Die Trübung (engl. Haze) ist messbar über den Haze-Wert, welcher kleiner als 3,5%, bevorzugt kleiner als 1%, besonders bevorzugt kleiner als 0,3% ist.

Der Haze-Wert beschreibt den Anteil des transmittierten Lichts, der von der durchstrahlten Probe nach vorne gestreut wird. Somit ist er ein Maß für die Opazität oder Trübung transparenter Materialien und quantifiziert Materialfehler, Partikel, Inhomogenitäten oder kristalline Phasengrenzen in dem Material oder seiner Oberfläche, die die klare Durchsicht stören. Das Verfahren zur Messung der Trübung wird in der Norm ASTM D 1003 beschrieben.

Bevorzugt weist der Träger eine nicht zu hohe Doppelbrechung auf, d.h. typischerweise eine mittlere optische Retardation von weniger als 1000 nm, bevorzugt von weniger als 700 nm, besonders bevorzugt von weniger als 300 nm auf.

Die Retardation R ist das mathematische Produkt aus der Doppelbrechung $\Delta n$ und der Dicke des Trägers d. Die automatische und objektive Messung der Retardation erfolgt mit einem bildgebenden Polarimeter, z.B. von der Firma ilis GmbH, Modell StainMatic® M3/M.

Die Retardation wird in senkrechter Inzidenz gemessen. Die für den Träger angegebenen Werte für die Retardation sind laterale Mittelwerte.

Der Träger hat, einschließlich eventueller ein oder beidseitiger Beschichtungen, typischerweise eine Dicke von 5 bis 2000 μm, bevorzugt 8 bis 300 μm, besonders bevorzugt 30 bis 200 μm und insbesondere 125 bis 175 μm oder 30 bis 45 μm.

Zusätzlich zu den Bestandteilen kann der Folienverbund ein oder mehrere Abdeckschichten auf der Photopolymerschicht aufweisen, um diese vor Schmutz und Umwelteinflüssen zu schützen. Hierzu können Kunststofffolien oder Folienverbundsysteme, aber auch Klarlacke verwendet werden.

Als Abdeckschichten werden bevorzugt Folienmaterialien analog den in der Trägerschicht eingesetzten Materialien verwendet, wobei diese eine Dicke von typischerweise 5 bis 200 μm, bevorzugt 8 bis 125 μm, besonders bevorzugt 20 bis 50 μm.

Bevorzugt sind Abdeckschichten mit einer möglichst glatten Oberfläche. Als Maß gilt die Rauigkeit bestimmt nach DIN EN ISO 4288 "Geometrische Produktspezifikation (GPS) - Oberflächenbeschaffenheit..." (engl. "Geometrical Product Specifications (GPS) - Surface texture...", Prüfbedingung R3z Vorderseite und Rückseite. Bevorzugte Rauigkeiten liegen im Bereich kleiner oder gleich 2 μm, bevorzugt kleiner oder gleich 0,5 μm.

Als Kaschierfolien werden bevorzugt PE- oder PET-Folien einer Dicke von 20 bis 60 μm verwendet, besonders bevorzugt wird eine Polyethylenfolie von 40 μm Dicke verwendet.

Es können weitere Schutzschichten, so z.B. eine untere Kaschierung der Trägerfolie Anwendung finden.

Ein weiterer Gegenstand der vorliegenden Erfindung ist die Verwendung der erfindungsgemäßen Medien zur Aufzeichnung visueller Hologramme, zur Herstellung von optischen Elementen, Bildern, Darstellungen sowie ein Verfahren zur Aufzeichnung von Hologrammen unter Verwendung der erfindungsgemäßen Polyurethanzusammensetzungen und den daraus zugänglichen Medien oder holografischen Filmen.

Mit den erfindungswesentlichen Photopolymerfolien können durch entsprechende Belichtungsprozesse Hologramme für optische Anwendungen im gesamten sichtbaren Bereich sowie im nahen UV-Bereich (300 - 800 nm) hergestellt werden. Visuelle Hologramme umfassen alle Hologramme, die nach dem Fachmann bekannten Verfahren aufgezeichnet werden können, darunter fallen unter anderem In-Line (Gabor) Hologramme, Off-Axis Hologramme, Full-Aperture Transfer Hologramme, Weißlicht-Transmissionshologramme ("Regenbogenhologramme"), Denisyukhologramme, Off-Axis Reflektionshologramme, Edge-Lit Hologramme sowie Holographische Stereogramme, bevorzugt sind Reflexionshologramme, Denisyukhologramme, Transmissionshologramme. Bevorzugt sind optische Elemente wie Linsen, Spiegel, Umlenkspiegel, Filter, Streuscheiben, Beugungselemente, Lichtleiter, Lichtlenker (waveguides), Projektionsscheiben und/oder Masken. Häufig zeigen diese optischen Elemente eine Frequenzselektivität je nachdem wie die Hologramme belichtet wurden und welche Dimensionen das Holgramm hat.

Zudem können mittels der erfindungswesentlichen Photopolymerfolien auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellten Produkten. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Designmöglichkeiten stellen Hologramme, insbesondere Volumenhologramme, eine attraktive technische Lösung für die oben genannten Anwendung dar.

### Beispiele:

Einsatzstoffe:

Desmodur® XP 2599 ist ein Versuchsprodukt der Bayer MaterialScience AG, Leverkusen, DE, Vollallophanat von Hexandiisocyanat auf Acclaim 4200, NCO-Gehalt: 5,6 - 6,4 %

Präpolymer 1 ist ein experimentelles Produkt der Bayer MaterialScience AG, Leverkusen, DE, Urethan von Hexandiisocyanat und Acclaim 2200, NCO-Gehalt: 3,2 - 3,75 %

Polyol 1 (Acclaim® 4200) ist ein Polypropylenoxid der zahlenmittleren Molmasse 4000 g/Mol der Bayer MaterialScience AG, Leverkusen, DE.

Polyol 2 (Acclaim® 4220 N) ist ein ethylenoxid-gecapptes Polypropylenoxid der zahlenmittleren Molmasse 4000 g/Mol der Bayer MaterialScience AG, Leverkusen, DE.

Polyol 3 (Acclaim® 2200) ist ein Polypropylenoxid der zahlenmittleren Molmasse 2000 g/Mol der Bayer MaterialScience AG, Leverkusen, DE.

Urethanacrylat 1 ist ein experimentelles Produkt der Bayer MaterialScience AG, Leverkusen, DE, Urethanacrylat auf Basis von HEA und Desmodur® RFE.

Fomrez® UL28: Urethanisierungskatalysator, Dimethylbis[(1-oxoneodecl)oxy]stannan, Handelsprodukt der Fa. Momentive Performance Chemicals, Wilton, CT, USA (als 10%ige Lösung in N-Ethylpyrrolidon eingesetzt).

CGI 909: Co-Initiator auf Boratbasis der Firma Ciba Inc., Basel, Schweiz.

Neu Methylenblau (zinkfrei): Farbstoff der Fa. Sigma-Aldrich Chemie GmbH, Steinheim, Deutschland.

Ethylviolett: Farbstoff der Fa.MP Biomedicals LLC, Solon, Ohio, USA.

Astrazon Orange G: Farbstoff der Fa. Sigma-Aldrich Chemie GmbH, Steinheim, Deutschland.

Byk 310: silikonbasiertes Oberflächenadditiv der Fa. BYK-Chemie GmbH, Wesel, Deutschland (Lösung ca. 25%-ig in Xylol).

Messung von Beugungswirkungsgrad DE und Brechungsindexkontrast Δn:

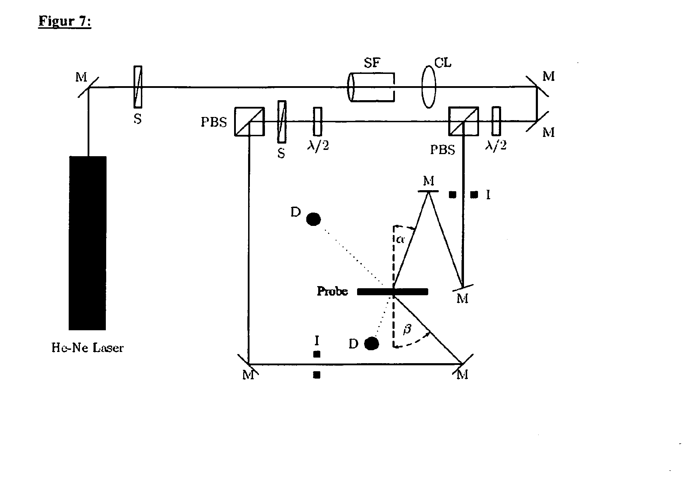

Die im Rahmen des experimentellen Teils hergestellten erfindungsgemäßen und Vergleichsmedien wurden mittels einer Messanordnung gemäß Figur 7 auf ihre holographischen Eigenschaften geprüft:

Figur 7: Geometrie eines Holographic Media Testers bei λ = 633 nm (He-Ne Laser)zum Schreiben eines Reflexionshologrammes: M = Spiegel, S = Verschluss, SF = Raumfilter, CL = Kollimatorlinse, λ/2 = λ/2 Platte, PBS = polarisationsempfindlicher Strahlteiler, D = Detektor, I = Irisblende, α = 21.8° und β = 41.8° sind die Einfallswinkel der kohärenten Strahlen ausserhalb der Probe (des Mediums) gemessen.

Dabei wird die Kaschierfolie vom Folienverbund abgezogen und das Photopolymermaterial anschließend so auf Glas laminiert, dass die Substratfolie nach außen zeigt.

Der Strahl eines He-Ne Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 4 mm. Die polarisationsabhängigen Strahlteiler (PBS) teilen den Laserstrahl in zwei kohärente gleich polarisierte Strahlen. Über die λ/2 Plättchen wurden die Leistung des Referenzstrahls of 0.5 mW und die Leistung des Signalstrahls auf 0.65 mW eingestellt. Die Leistungen wurden mit den Halbleiterdetektoren (D) bei ausgebauter Probe bestimmt. Der Einfallswinkel (α) des Referenzstrahls beträgt 21.8°, der Einfallswinkel (β) des Signalstrahls beträgt 41.8°. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand im Medium beträgt ∼ 225 nm (Brechungsindex des Mediums zu ∼1.49 angenommen).

Es wurden auf folgende Weise Hologramme in das Medium geschrieben:

Beide Shutter (S) sind für die Belichtungszeit t geöffnet. Danach wurde bei geschlossenen Shuttern (S) dem Medium 5 Minuten Zeit für die Diffusion der noch nicht polymerisierten Schreibmonomere gelassen. Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man, dass für alle Drehwinkel (Ω) des Mediums der Strahl immer vollständig im zuvor geschriebenen Hologramm lag. Der Drehtisch überstrich nun computergesteuert den Winkelbereich von Ω = 0° bis Ω = 20° mit einer Winkelschrittweite von 0.05°. An jedem angefahrenen Winkel wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz η ergab sich bei jedem angefahrenen Winkel Ω als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad η in Abhängigkeit des Drehwinkels Ω des geschriebenen Hologramms gemessen und in einem Computer gespeichert. Zusätzlich wurde auch die in die nullte Ordnung transmittierte Intensität gegen der Drehwinkel Ω aufgezeichnet und in einem Computer gespeichert.

Die maximale Beugungseffizienz (DE = $\eta_{max}$) des Hologramms, also sein Spitzenwert, wurde ermittelt. Eventuell musste dazu die Position des Detektors des abgebeugten Strahls verändert werden, um diesen maximalen Wert zu bestimmen.

Der Brechungsindexkontrast Δn und die Dicke d der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelverlauf der transmittierten Intensität ermittelt. Das Verfahren wird im folgenden beschrieben:

Für die Braggkurve η/(Ω) eines Reflexionshologramms gilt nach Kogelnik:

$$\eta = \frac{1}{1 + \dfrac{1 - (\chi/\Phi)^2}{\sinh^2\left(\sqrt{\Phi^2 - \chi^2}\right)}}$$

mit:

$$\Phi = \frac{\pi \cdot \Delta n \cdot d}{\lambda \cdot \sqrt{\cos(\alpha') \cdot \cos(\alpha' - 2\psi)}}$$

$$\chi = \Delta\theta \cdot \frac{2\pi \cdot \sin(\alpha' - \psi)}{\Lambda \cdot \cos(\alpha' - 2\psi)} \cdot \frac{d}{2}$$

$$\psi = \frac{\beta' - \alpha'}{2}$$

$$\Lambda = \frac{\lambda}{2 \cdot n \cdot \cos(\psi - \alpha')}$$

$$n \cdot \sin(\alpha') = \sin(\alpha), \, n \cdot \sin(\beta') = \sin(\beta)$$

$$\Delta\theta = -\Delta\Omega \cdot \sqrt{\frac{1 - \sin^2(\alpha)}{n^2 - \sin^2(\alpha)}}$$

$\Phi$ ist die Gitterstärke, $\chi$ ist der Detuning Parameter und $\Psi$ der Kippwinkel des Brechungsindexgitters, das geschrieben wurde. $\alpha'$ und $\beta'$ entsprechen den Winkeln $\alpha$ und $\beta$ beim Schreiben des Hologramms, aber im Medium. $\Delta\Theta$ ist das Winkeldetuning gemessen im Medium, also die Abweichung vom Winkel $\alpha'$. $\Delta\Omega$ ist das Winkeldetuning gemessen außerhalb des Mediums, also die Abweichung vom Winkel $\alpha$. n ist der mittlere Brechungsindex des Photopolymers und wurde zu 1.504 gesetzt.

Die maximale Beugungseffizienz (DE = $\eta_{max}$) ergibt sich dann für $\chi = 0$, also $\Delta\Omega = 0$ zu:

$$DE = \tanh^2(\Phi) = \tanh^2\left(\frac{\pi \cdot \Delta n \cdot d}{\lambda \cdot \sqrt{\cos(\alpha') \cdot \cos(\alpha' - 2\psi)}}\right)$$

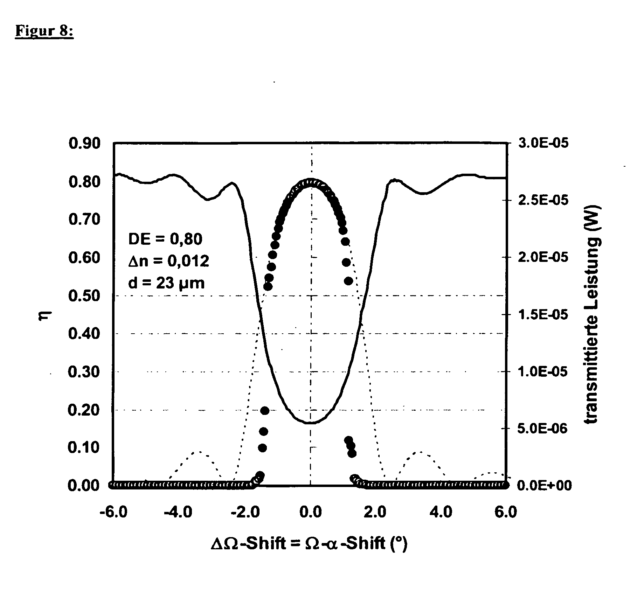

Die Messdaten der Beugungseffizienz, die theoretische Braggkurve und die transmittierte Intensität werden wie in Figur 8 gezeigt gegen den zentrierten Drehwinkel $\Omega$-$\alpha$-Shift aufgetragen. Da wegen geometrischem Schrumpf und der Änderung des mittleren Brechungsindexes bei der Photopolymerisation der Winkel bei dem DE gemessen wird von $\alpha$ abweicht wird die x-Achse um diesen Shift zentriert. Der Shift beträgt typischerweise 0° bis 2°.

Da DE bekannt ist wird die Form der theoretischen Braggkurve nach Kogelnik nur noch durch die Dicke d der Photopolymerschicht bestimmt. $\Delta n$ wird über DE für gegebene Dicke d so nachkorrigiert, dass Messung und Theorie von DE immer übereinstimmen. d wird nun solange angepasst bis die Winkelpositionen der ersten Nebenminima der theoretischen Braggkurve mit den Winkelpositionen der ersten Nebenmaxima der transmittierten Intensität übereinstimmen und zudem die volle Breite bei halber Höhe (FWHM) für theoretische Braggkurve und die transmittierte Intensität übereinstimmen.

Da die Richtung, in die ein Reflexionshologramm bei der Rekonstruktion mittels eines $\Delta$-Scans mitrotiert, der Detektor für das abgebeugte Licht aber nur einen endlichen Winkelbereich erfassen kann, wird die Braggkurve von breiten Holgrammen (kleines d) bei einem $\Omega$-Scan nicht vollständig erfasst, sondern nur der zentrale Bereich, bei geeigneter Detektorpositionierung. Daher wird die zur Braggkurve komplementäre Form der transmittierten Intensität zur Anpassung der Schichtdicke d zusätzlich herangezogen.

Figur 8: Darstellung der Braggkurve $\eta$ nach Kogelnik (gestrichelte Linie), des gemessenen Beugungswirkungsgrades (ausgefüllte Kreise) und der transmittierten Leistung (schwarz durchgezogene Linie) gegen das Winkeldetuning $\Delta\Omega$. Da wegen geometrischem Schrumpf und der Änderung des mittleren Brechungsindexes bei der Photopolymerisation der Winkel bei dem DE gemessen wird von $\alpha$ abweicht wird die x-Achse um diesen Shift zentriert. Der Shift beträgt typischerweise 0° bis 2°.

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis E ergibt sich wie folgt:

$$E\,(\mathrm{mJ/cm^2}) = \frac{2 \cdot \big[0.50\,\mathrm{mW} + 0.67\,\mathrm{mW}\big] \cdot t\,(\mathrm{s})}{\pi \cdot 0.4^2\,\mathrm{cm^2}}$$

Die Leistungen der Teilstrahlen wurden so angepasst, dass in dem Medium bei den verwendeten Winkeln $\alpha$ und $\beta$, die gleiche Leistungsdichte erreicht wird.

Alternativ wurde auch ein dem in Figur 7 dargestellten Aufbau äquivalenter Test mit einem grünen Laser mit der Emissionswellenlänge $\lambda$ im Vakuum von 532 nm durchgeführt. Dabei beträgt $\alpha$ = 11.5° und $\beta$ = 33.5° und $P_\alpha$ = 1.84 mW und $P_\beta$ = 2.16 mW.

Die physikalische Schichtdicke wurde mit marktgängigen Weisslichtinterferometern ermittelt, wie z.B. das Gerät FTM-Lite NIR Schichtdickenmessgerät der Firma Ingenieursbüro Fuchs.

Die Bestimmung der Schichtdicke beruht im Prinzip auf Interferenzerscheinungen an dünnen Schichten. Dabei überlagern sich Lichtwellen, die an zwei Grenzflächen unterschiedlicher optischer Dichte reflektiert worden sind. Die ungestörte Überlagerung der reflektierten Teilstrahlen führt nun zur periodischen Aufhellung und Auslöschung im Spektrum eines weißen Kontinuumstrahlers (z.B. Halogenlampe). Diese Überlagerung nennt der Fachmann Interferenz. Diese Interferenzspektren werden gemessen und mathematisch ausgewertet.

Herstellung des Urethanacrylats 1:

In einem 500 mL Rundkolben wurden 0.1 g 2,6-Di-tert.-butyl-4-methylphenol, 0.05 g Dibutylzinndilaurat (Desmorapid Z, Bayer MaterialScience AG, Leverkusen, Deutschland) sowie und 213.07 g einer 27 %-igen Lösung von Tris (p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten.

**Vergleichsbeispiell 1 (Photopolymer, intern HOEN 0076):**

10,222 g Polyol 1 (Komponente B) wurden schrittweise mit 5,00 g Urethanacrylat 1 (Komponente C), dann 0,100 g Fomrez® UL 28 (Komponente F) und 0,060 g Byk 310 (Komponente G), und zuletzt einer Lösung von 0,300 g CGI 909, 0.010 g Neu Methylenblau, 0,010 g Ethylviolett und 0,010 g Astrazon Orange G (zusammen Komponente E) in 0,610 g N-Ethylpyrolidon (Komponente G) im Dunkeln versetzt und gemischt, so dass eine klare Lösung erhalten wurde. Anschließend wurden bei 30 °C 3,678 g Desmodur® XP 2599 (Komponente A) zugegeben und erneut gemischt. Die erhaltene, flüssige Masse wurde dann mit einem automatisch angetriebenen Filmziehrakel mit einer Ziehgeschwindigkeit von 3 mm/Sekunde und einem Rakelspalt von 50 $\mu$m auf eine 175 $\mu$m dicke Polycarbonatfolie appliziert und 4,5 Minuten bei 80°C getrocknet. Trockenschichtdicke: 30$\mu$m, maximaler $\Delta$n: 0,012 (633 nm)

Zur erfindungsgemäßen kontinuierlichen Herstellung der holografischen Folienmaterialien werden die Komponente C, die Komponente D (die bereits in der Komponente C vorgelöst sein kann) sowie gegebenenfalls die Komponente G und F in der Komponente B gegebenenfalls bei 60 °C gelöst und gründlich gemischt. Danach wird im Dunklen oder unter geeigneter Beleuchtung die Komponente E in reiner Form oder in verdünnter Lösung in NEP zugewogen und erneut gemischt. Gegebenenfalls wird maximal 10 Minuten im Trockenschrank auf 60 °C erhitzt. Die erhaltene Mischung kann unter Rühren bei < 10 mbar entgast werden.

Die Komponente A kann ebenfalls unter Rühren bei < 10 mbar entgast werden. Anschließend werden beide Formulierungen mittels Zwangsdosierpumpen über einen der oben genannten Mischverfahren kontinuierlich dosiert und vermischt. Danach wird die Mischung über eine Applikationseinheit, wie z.B. ein Rakel oder eine Schlitzdüse kontinuierlich und homogen auf eine Trägerfolie appliziert.

Die beschichteten Trägerfolien werden bei ca. 80 °C getrocknet und anschließend mit einer der oben genannten Abdeckschichten abgedeckt und in einer lichtdichten Verpackung verpackt.

Die Dicke d der Photopolymerschicht ergibt sich aus den dem Fachmann bekannten Beschichtungsparametem der entsprechenden Beschichtungseinrichtung.

Die folgenden Beispiele sind zur Erläuterung der erfindungsgemäßen Methode genannt, sollen aber nicht als begrenzend verstanden sein. Sofern nicht abweichend vermerkt beziehen sich alle Prozentangaben der Photopolymere auf Gewichtsprozent.

### Beispiel 1 (Photopolymer, intern KOHC 178-07):

27,83 g Polyol 1 (Komponente B) wurden schrittweise mit 13,75 g Urethanacrylat 1 (Komponente C), dann 0.275 g Fomrez® UL 28 (Komponente F) und 0,165 g Byk 310 (Komponente G), und zuletzt einer Lösung von 0,825 g CGI 909, 0.028 g Neu Methylenblau, 0,028 g Ethylviolett und 0,028 g Astrazon Orange G (zusammen Komponente E) in 1,678 g N-Ethylpyrolidon (Komponente G) im Dunkeln versetzt und gemischt, so dass eine klare Lösung erhalten wurde. Anschließend wurden bei 30 °C 10,395 g Desmodur® XP 2599 (Komponente A) zugegeben und erneut gemischt. Die erhaltene, flüssige Masse wurde dann auf eine 175 $\mu$m dicke Polycarbonatfolie appliziert und 4,5 Minuten bei 80°C getrocknet. Trockenschichtdicke: 45$\mu$m, maximaler $\Delta$n: 0,016 (633 nm); 0,017 (532 nm).

### Beispiel 2 (Photopolymer, intern KOHC 246-05):

10,245 g Polyol 2 (Komponente B) wurden schrittweise mit 5,00 g Urethanacrylat 1 (Komponente C), dann 0,100 g Fomrez® UL 28 (Komponente F) und 0,060 g Byk 310 (Komponente G), und zuletzt einer Lösung von 0,300 g CGI 909, 0.010 g Neu Methylenblau, 0,010 g Ethylviolett und 0,010 g Astrazon Orange G (zusammen Komponente E) in 0,610 g N-Ethylpyrolidon (Komponente G) im Dunkeln versetzt und gemischt, so dass eine klare Lösung erhalten wurde. Anschließend wurden bei 30 °C 3,655 g Desmodur® XP 2599 (Komponente A) zugegeben und erneut gemischt. Die erhaltene, flüssige Masse wurde dann auf eine 175 $\mu$m dicke Polycarbonatfolie appliziert und 4,5 Minuten bei 80°C getrocknet. Trockenschichtdicke: 25 $\mu$m, maximaler $\Delta$n: 0,012 (633 nm); 0,010 (532 nm).

### Beispiel 3 (Photopolymer, intern KOHC 173-02):

19,946 g Polyol 3 (Komponente B) wurden schrittweise mit 13,75 g Urethanacrylat 1 (Komponente C), dann 0.275 g Fomrez® UL 28 (Komponente F) und 0,165 g Byk 310 (Komponente G), und zuletzt einer Lösung von 0,825 g CGI 909, 0.028 g Neu Methylenblau, 0,028 g Ethylviolett und 0,028 g Astrazon Orange G (zusammen Komponente E) in 1,678 g N-Ethylpyrolidon (Komponente G) im Dunkeln versetzt und gemischt, so dass eine klare Lösung erhalten wurde. Anschließend wurde bei 30 °C eine Mischung aus 6,467 g Desmodur®XP 2599 und 11,812 g Präpolymer 1 (zusammen Komponente A) zugegeben und erneut gemischt. Die erhaltene, flüssige Masse wurde dann auf eine 175 $\mu$m dicke Polycarbonatfolie appliziert und 4,5 Minuten bei 80°C getrocknet. Trockenschichtdicke: 32$\mu$m, maximaler $\Delta$n: 0,016 (633 nm); 0,017 (532 nm).

### Beispiel 4 (Photopolymer, intern KOHC 227-07):

8,432 g Polyol 3 (Komponente B) wurden schrittweise mit 5,00 g Urethanacrylat 1 (Komponente C), dann 0,100 g Fomrez® UL 28 (Komponente F) und 0,060 g Byk 310 (Komponente G), und zuletzt einer Lösung von 0,300 g CGI 909, 0.010 g Neu Methylenblau, 0,010 g Ethylviolett und 0,010 g Astrazon Orange G (zusammen Komponente E) in 0,610 g N-Ethylpyrolidon (Komponente G) im Dunkeln versetzt und gemischt, so dass eine klare Lösung erhalten wurde. Anschließend wurden bei 30 °C 5,468 g Desmodur® XP 2599 (Komponente A) zugegeben und erneut gemischt. Die erhaltene, flüssige Masse wurde dann auf eine 36 $\mu$m dicke Polyethylenterephthalatfolie appliziert und 4,5 Minuten bei 80°C getrocknet. Trockenschichtdicke: 30$\mu$m, maximaler $\Delta$n: 0,013 (633 nm); 0,014 (532 nm).

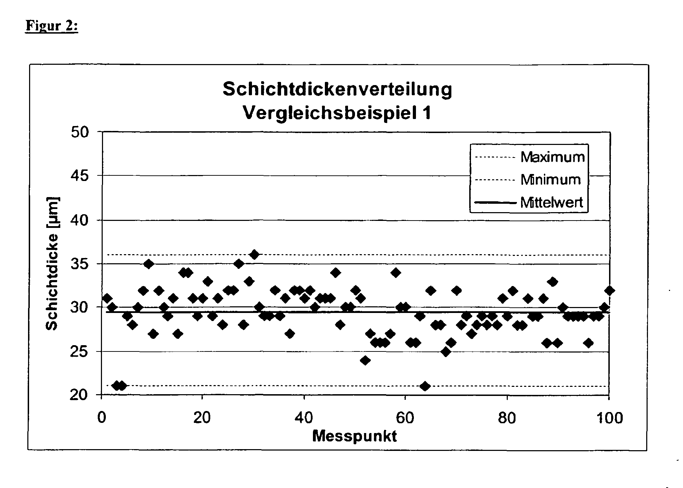

Figur 2 zeigt eine topografische Schichtdickenverteilung mit einer herkömmlichen Laborbeschichtungseinrichtung, wie z.B. Handziehrahmen, Spiralapplikatoren oder einem automatisch angetriebenen Filmapplikator (Vergleichsbeispiel 1). Bei diesen Verfahren wird ein ausreichendes Volumen an Beschichtungsmaterial vor den Applikator gegeben. Anschließend wird der Applikator manuell mit einer nahezu gleichmäßigen Geschwindigkeit über das Trägermaterial gezogen, sodass ein gleichmäßiger Film auf dem Trägermaterial entsteht. Dieses kann mit einem automatisch angetriebenen Filmziehgerät ergänzt und somit optimiert werden. Des Weiteren wird die Beschichtungsqualität von den beschriebenen Verfahren stark durch die Wahl eines geeigneten Untergrunds beeinflusst. Hierbei werden bevorzugt Glas- und Gummimaterialien eingesetzt.

Figur 2: Schichtdickenverteilung bei der Herstellung mit herkömmlichen Laborbeschichtungseinrichtungen

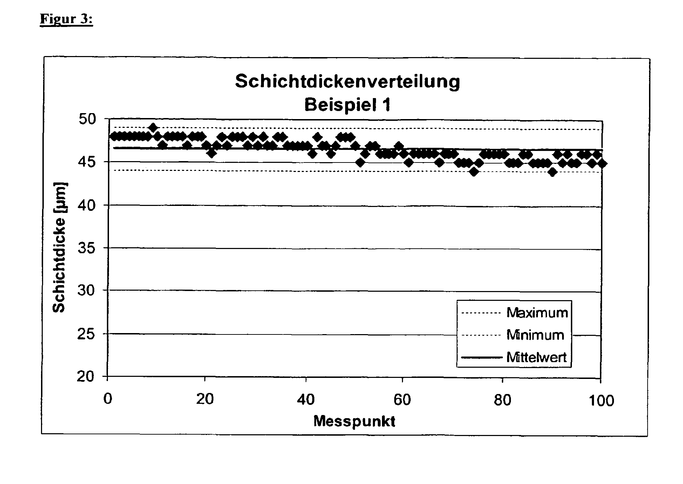

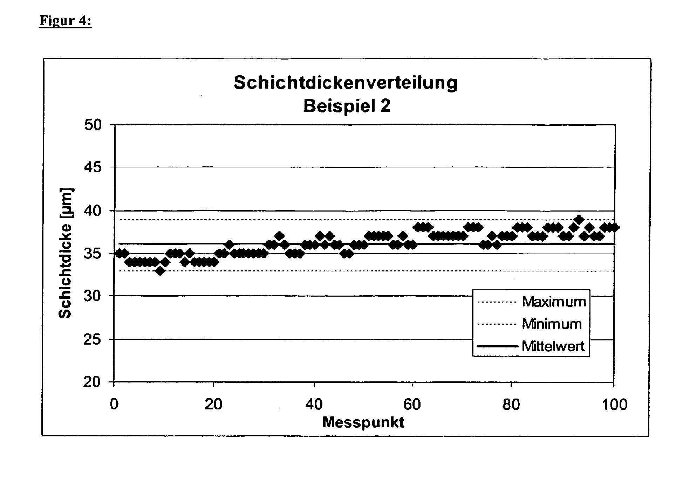

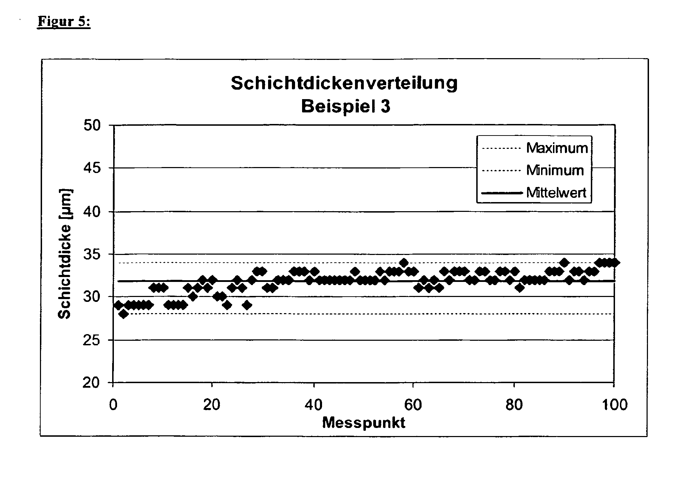

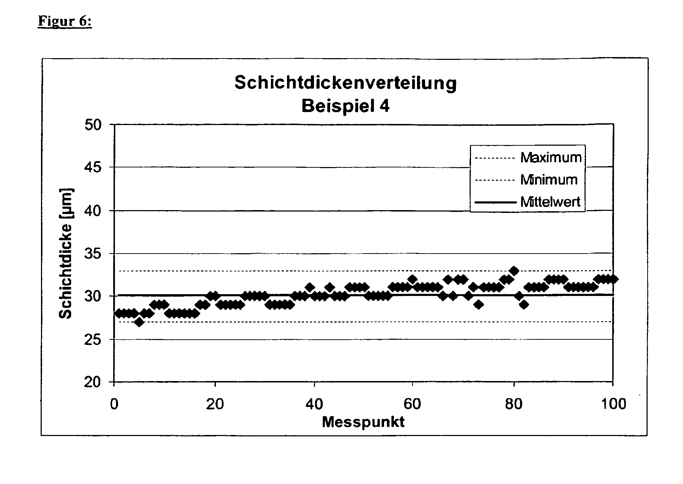

Wie in Figur 3-7 gezeigt, lässt sich durch die in Figur 1 dargestellte kontinuierliche Rollenbeschichtung eine höhere Schichtdickengenauigkeit erzielen. Eine Zusammenstellung der erzielten Resultate zeigt Tabelle 1. Die Verbesserung der Schichtdickenverteilung von Beispiel 1 können eindeutig an der Reduzierung der Standardabweichung mit dem Einsatz der Rollenbeschichtung (Beispiel 2-5) gezeigt werden. Des weiteren zeigen die Vergleiche der minimal und der maximal gemessenen Schichtdicken (siehe Differenz) eine deutliche Verringerung der Bandbreite der erzielten Schichtdicken. Damit werden gleichmäßigere Beschichtungen erreicht. Das Erzielen einer gleichmäßigen Schichtdik-

kenverteilung des Photopolymers ist wichtig, um eine gleichmäßige Helligkeit der Hologramme über eine größere Fläche garantieren zu können. Da die Helligkeit der Hologramme direkt von den Beugungseffizienzen und den spektralen Winkelbandbreiten abhängt, ist somit auch ein direkter Einfluss der Schichtdicke über diese Parameter gegeben.

Tabelle 1: Vergleich der Schichtdickenauswertung

| | | Standard- | Maximum | Minimum | Differenz |
|---|---|---|---|---|---|
| Nummer | Mittelwert | abweichung | | | |
| | [$\mu$m] | [$\mu$m] | [$\mu$m] | [$\mu$m] | [$\mu$m] |
| Vergleichsbeispiel 1 | 29,5 | 2,8 | 36 | 21 | 15 |
| Beispiel 1 | 46,6 | 1,2 | 49 | 44 | 5 |
| Beispiel 2 | 36,2 | 1,4 | 39 | 33 | 6 |
| Beispiel 3 | 31,8 | 1,4 | 34 | 28 | 6 |
| Beispiel 4 | 30,2 | 1,3 | 33 | 27 | 6 |

Figur 3-7: Optimierte Schichtdickenverteilung bei der Herstellung mit einer kontinuierlichen Rollenbeschichtung

**Patentansprüche**

1. Kontinuierliches Verfahren zur Herstellung von Photopolymerfolien, bei dem eine Trägerfolie nach dem Rolle-zu-Rolle-Prinzip mit einer Photopolymerformulierung umfassend

   A) eine Polyisocyanatkomponente, wenigstens enthaltend ein NCO-terminiertes Polyurethanprepolymer dessen NCO-Gruppen primär aliphatisch gebunden sind und welches auf hydroxyfunktionellen Verbindungen mit einer OH-Funktionalität von 1,6 bis 2,05 basiert,
   B) Isocyanat-reaktive Polyetherpolyole
   C) Urethanacrylate und/oder Urethanmethacrylate mit mindestens einer aromatischen Struktureinheit und einem Brechungsindex von größer 1,50 bei 405 nm, die selbst frei von NCO-Gruppen und OH-Gruppen sind
   D) Radikalstabilisatoren
   E) Photoinitiatoren auf Basis von Kombinationen aus Boratsalzen und einem oder mehreren Farbstoffen mit Absorptionsbanden, die zumindest teilweise den Spektralbereich von 400 bis 800 nm abdecken.
   F) Gegebenenfalls Katalysatoren
   G) Gegebenenfalls Hilfs- und Zusatzstoffe.

   beschichtet wird.

2. Verfahren gemäß Anspruch 1, **dadurch gekennzeichnet, dass** in A) als Prepolymere Urethane oder Allophanate aus aliphatischen Isocyanat-funktionellen Verbindungen und oligomeren oder polymeren Isocyanat-reaktiven Verbindungen eingesetzt werden, wobei die Prepolymere zahlenmittlere Molmassen von 200 bis 10000 g/Mol und NCO-Funktionalitäten von 1,9 bis 5,0 aufweisen.

3. Verfahren gemäß Anspruch 1 oder 2, **dadurch gekennzeichnet, dass** in B) difunktionelle Polyetherpolyole, basierend auf Propylenoxid und Ethylenoxid mit einem Ethylenoxidanteil von kleiner 10 Gewichtsprozent bezogen auf die Gesamtmasse des zugrundeliegenden Polyethers, und einer zahlenmittleren Molmasse zwischen 2000 und 4200 g/mol eingesetzt werden.

4. Verfahren gemäß Anspruch 1 oder 2, **dadurch gekennzeichnet, dass** in C) als Urethanacrylate Additionsprodukte aromatischer Triisocyanate oder Trimere aromatischer Diisocyanate mit Hydroxyethylacrylat, Hydroxypropylacrylat, 4-Hydroxybutylacrylat eingesetzt werden.

5. Verfahren gemäß einem der Ansprüche 1 bis 4, **dadurch gekennzeichnet, dass** dabei die nachfolgenden Prozesschritte durchlaufen werden:

   I. Fördern und Dosieren zum einen der Komponente A) gegebenenfalls gemischt mit einer oder mehrerer der Komponenten E), F) und G) sowie zum anderen separat dazu der Komponente B) gegebenenfalls gemischt mit einer oder mehrerer der Komponenten C), D), E), F) und G)

II. Entgasen der gemäß I) geförderten, dosierten und gegebenenfalls vorvermischten Ströme

III. Filtrieren der nach In erhaltenen Mischung

IV. Homogenisieren der nach III) erhaltenen Mischung

V. Abwicklung und Vorbehandlung des Trägermaterials

VI. Beschichten des Trägermaterial mit der nach Schritt IV) erhaltenen Mischung

VII. Trocknung des nach VI) beschichteten Films

VIII. Kaschieren des nach VII) erhaltenen beschichteten Films

IX. Aufwicklung des nach VIII) erhaltenen kaschierten Films

6. Verfahren gemäß Anspruch 5, **dadurch gekennzeichnet, dass** Dosierung der Einsatzstoffe in Schritt I) entweder durch Zahnrad- oder Excenterschneckenpumpen, die Entgasung der Einsatzstoffe in II) Zentrifugalentgaser, zur Filterung in III) Plattenfilter, die Mischung der Einzelkomponenten in IV) über statische Mischer, als Beschichtungseinheit in VI) eine Schlitzdüse und das beschichtete Material in VII) über Lufttrockner getrocknet wird.

7. Verfahren gemäß einem der Ansprüche 1 bis 6, **dadurch gekennzeichnet, dass** als Trägerfolie Polycarbonat (PC), Polyethylenterephthalat (PET), Polybutylenterephthalat, Polyethylen, Polypropylen, Celluloseacetat, Cellulosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral oder Polydicyclopentadien oder deren Mischungen verwendet wird.

8. Verfahren gemäß einem der Ansprüche 1 bis 7, **dadurch gekennzeichnet, dass** die Trägerfolie optisch klar ist und eine Trübung gemessen als Haze-Wert von kleiner als 3,5% aufweist.

9. Verfahren gemäß einem der Ansprüche 1 bis 8, **dadurch gekennzeichnet, dass** die Trägerfolie eine mittlere optische Retardation von weniger als 1000 nm aufweist.

10. Verfahren gemäß einem der Ansprüche 1 bis 8, **dadurch gekennzeichnet, dass** die Trägerfolie eine Dicke von 5 bis 2000 $\mu$m aufweist.

11. Verfahren gemäß einem der Ansprüche 5 bis 10, **dadurch gekennzeichnet, dass** zur Kaschierung PE- oder PET-Folien einer Dicke von 20 bis 60 $\mu$m verwendet werden.

12. Photopolymerfolien geeignet zur Aufzeichnung visueller Hologramme erhältlich nach einem Verfahren gemäß einem der Ansprüche 1 bis 11.

13. Verwendung von Photopolymerfolien gemäß Anspruch 7 als optische Elemente, Bilder oder zur Bilddarstellung oder-projektion.

**Claims**

1. Continuous process for the production of photopolymer films, in which a support film is coated by the roll-to-roll principle with a photopolymer formulation comprising

A) a polyisocyanate component, at least containing an NCO-terminated polyurethane prepolymer whose NCO groups are primarily aliphatically bonded and which is based on hydroxy-functional compounds having an OH functionality of 1.6 to 2.05,

B) isocyanate-reactive polyether polyols

C) urethane acrylates and/or urethane methacrylates having at least one aromatic structural unit and a refractive index of greater than 1.50 at 405 nm, which themselves are free of NCO groups and OH groups

D) free radical stabilizers

E) photoinitiators based on combinations of borate salts and one or more dyes having absorption bands which at least partly cover the spectral range from 400 to 800 nm

F) optionally catalysts

G) optionally auxiliaries and additives.

**2.** Process according to Claim 1, **characterized in that** urethanes or allophanates of aliphatic isocyanate-functional compounds and oligomeric or polymeric isocyanate-reactive compounds are used as prepolymers in A), the prepolymers having number average molar masses of 200 to 10 000 g/mol and NCO functionalities of 1.9 to 5.0.

**3.** Process according to Claim 1 or 2, **characterized in that** difunctional polyether polyols based on propylene oxide and ethylene oxide, having a proportion of ethylene oxide of less than 10 per cent by weight, based on the total mass of the parent polyether, and a number average molar mass between 2000 and 4200 g/mol, are used in B).

**4.** Process according to Claim 1 or 2, **characterized in that** adducts of aromatic triisocyanates or trimers of aromatic diisocyanates with hydroxyethyl acrylate, hydroxypropyl acrylate, 4-hydroxybutyl acrylate are used as urethane acrylates in C).

**5.** Process according to any of Claims 1 to 4, **characterized in that** the following process steps are implemented:

I. transport and metering firstly of the component A), optionally mixed with one or more of the components E), F) and G), and secondly, separately therefrom, of the component B), optionally mixed with one or more of the components C), D), E), F) and G)
II. devolatilization of the streams transported, metered and optionally premixed according to I)
III. filtration of the mixture obtained according to II)
IV. homogenization of the mixture obtained according to III)
V. unrolling and pretreatment of the support material
VI. coating the support material with the mixture obtained according to step IV)
VII. drying of the film coated according to VI)
VIII. lamination of the coated film obtained according to VII)
IX. rolling up of the laminated film obtained according to VIII).

**6.** Process according to Claim 5, **characterized in that** metering of the starting materials in step I) is carried out either by gear or eccentric screw pumps, for the devolatilization of the starting materials in II) centrifugal degasers are used, for filtration in III) plate filters are used, the mixing of the individual components is carried out in IV) via static mixers, as coating unit in VI) a slot nozzle is used and the coated material is dried in VII) via air dryers.

**7.** Process according to any of Claims 1 to 6, **characterized in that** polycarbonate (PC), polethylene terephthalate (PET), polybutylene terephthalate, polyethylene, polypropylene, cellulose acetate, cellulose hydrate, cellulose nitrate, cycloolefin polymers, polystyrene, polyepoxides, polysulfone, cellulose triacetate (CTA), polyamide, polymethyl methacrylate, polyvinyl chloride, polyvinyl butyral and polydicyclopentadiene or mixtures thereof is used as the support film.

**8.** Process according to any of Claims 1 to 7, **characterized in that** the support film is optically transparent and has a haze, measured as the haze value, of less than 3.5%.

**9.** Process according to any of Claims 1 to 8, **characterized in that** the support film has a mean optical retardation of less than 1000 nm.

**10.** Process according to any of Claims 1 to 8, **characterized in that** the support film has a thickness of 5 to 2000 $\mu$m.

**11.** Process according to any of Claims 5 to 10, **characterized in that** PE or PET films having a thickness of 20 to 60 $\mu$m are used for the lamination.

**12.** Photopolymer films suitable for recording visual holograms, obtainable by a process according to any of Claims 1 to 11.

**13.** Use of photopolymer films according to Claim 7 as optical elements or images or for image display or projection.

**Revendications**

**1.** Procédé continu pour la préparation de feuilles en photopolymère, dans lequel une feuille support est revêtue selon le principe rouleau à rouleau par une formulation de photopolymère comprenant

A) un composant polyisocyanate, contenant au moins un prépolymère de polyuréthane terminé par NCO, dont les groupes NCO sont liés aliphatiquement de manière primaire et qui est à base de composés à fonctionnalité hydroxy présentant une fonctionnalité OH de 1,6 à 2,05,

B) des polyétherpolyols réactifs avec isocyanate

C) des uréthane-acrylates et/ou des uréthane-méthacrylates présentant au moins une unité de structure aromatique et un indice de réfraction supérieur à 1,50 à 405 nm, qui sont eux-mêmes exempts de groupes NCO et OH

D) des stabilisateurs de radicaux

E) des photo-initiateurs à base de combinaisons de sels de borate et d'un ou de plusieurs colorants présentant des bandes d'absorption qui recouvrent au moins partiellement la plage spectrale de 400 à 800 nm,

F) le cas échéant des catalyseurs

G) le cas échéant des adjuvants et des additifs.

2. Procédé selon la revendication 1, **caractérisé en ce qu'**on utilise dans A) comme prépolymères des uréthanes ou des allophanates en composés aliphatiques à fonctionnalité isocyanate et des composés oligomères ou polymères réactifs avec isocyanate, les prépolymères présentant des masses molaires numériques moyennes de 200 à 10 000 g/mole et des fonctionnalités NCO de 1,9 à 5,0.

3. Procédé selon la revendication 1 ou 2, **caractérisé en ce qu'**on utilise dans B) des polyétherpolyols difonctionnels à base d'oxyde de propylène et d'oxyde d'éthylène présentant une proportion d'oxyde d'éthylène inférieure à 10% en poids par rapport à la masse totale du polyéther de base et une masse molaire numérique moyenne entre 2000 et 4200 g/mole.

4. Procédé selon la revendication 1 ou 2, **caractérisé en ce qu'**on utilise dans C) comme uréthane-acrylates des produits d'addition de triisocyanates aromatiques ou de trimères de diisocyanates aromatiques avec de l'acrylate d'hydroxyéthyle, de l'acrylate d'hydroxypropyle, de l'acrylate de 4-hydroxybutyle.

5. Procédé selon l'une quelconque des revendications 1 à 4, **caractérisé en ce que** les étapes de procédé suivantes se déroulent :

   I. alimentation et dosage d'une part du composant A), le cas échéant en mélange avec un ou plusieurs composants E), F) et G) ainsi que d'autre part, séparément, du composant B), le cas échéant en mélange avec un ou plusieurs des composants C), D), E), F) et G)

   II. dégazage des flux alimentés, dosés et le cas échéant prémélangés selon I)

   III. filtration du mélange obtenu selon II)

   IV. homogénéisation du mélange obtenu selon III)

   V. déroulement et prétraitement du matériau support

   VI. revêtement du matériau support par le mélange obtenu selon l'étape IV)

   VII. séchage du film revêtu selon VI)

   VIII. contrecollage du film revêtu obtenu selon VII)

   IX. enroulement du film contrecollé obtenu selon VIII)

6. Procédé selon la revendication 5, **caractérisé en ce que** le dosage des substances de départ dans l'étape I) a lieu soit par des pompes à engrenage, soit par des pompes à vis excentrique, on utilise, pour le dégazage des substances de départ dans II) des dégazeurs centrifuges, on utilise, pour la filtration dans III) des filtres à plaques, le mélange des différents composants dans IV) a lieu via des mélangeurs statiques, on utilise comme unité de revêtement dans VI) une filière plate et le matériau revêtu est séché dans VII) via un sécheur à air.

7. Procédé selon l'une quelconque des revendications 1 à 6, **caractérisé en ce qu'**on utilise comme feuille support du polycarbonate (PC), du poly(téréphtalate d'éthylène) (PET), du poly(téréphtalate de butylène), du polyéthylène, du polypropylène, de l'acétate de cellulose, de la cellulose hydratée, du nitrate de cellulose, des polymères de cyclooléfine, du polystyrène, des polyépoxydes, du polysulfone, du triacétate de cellulose (CTA), du polyamide, du poly(méthacrylate de méthyle), du poly(chlorure de vinyle), du polyvinylbutyral ou du polydicyclopentadiène ou leurs mélanges.

8. Procédé selon l'une quelconque des revendications 1 à 7, **caractérisé en ce que** la feuille support est optiquement claire et présente un trouble, mesurée par la valeur de voile, inférieur à 3,5%.

9. Procédé selon l'une quelconque des revendications 1 à 8, **caractérisé en ce que** la feuille support présente un retard optique moyen de moins de 1000 nm.

**10.** Procédé selon l'une quelconque des revendications 1 à 8, **caractérisé en ce que** la feuille support présente une épaisseur de 5 à 2000 μm.

**11.** Procédé selon l'une quelconque des revendications 5 à 10, **caractérisé en ce qu'**on utilise, pour le contrecollage, des feuilles de PE ou de PET d'une épaisseur de 20 à 60 μm.

**12.** Feuilles en photopolymère appropriées pour enregistrer des hologrammes visuels pouvant être obtenues selon un procédé selon l'une quelconque des revendications 1 à 11.

**13.** Utilisation de feuilles en photopolymère selon la revendication 7 comme éléments optiques, images ou pour la représentation ou la projection d'images.

**Figur 1:**

**Figur 2:**

**Figur 3:**

**Figur 4:**

Schichtdickenverteilung
Beispiel 2

**Figur 5:**

Schichtdickenverteilung
Beispiel 3

Figur 6:

Schichtdickenverteilung
Beispiel 4

**Figur 7:**

**Figur 8:**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 08017279 A
- EP 08017277 A
- EP 08017273 A
- EP 08017275 A

**In der Beschreibung aufgeführte Nicht-Patentliteratur**

- **P. M. SCHWEIZER.** Vordosierte Beschichtungsverfahren: Vorzüge und Anwendungen. Dezember 1998, 462-465
- 5- oder 6-Walzen Beschichtungsverfahren. Oktober 2006, 410-413
- **H. KOGELNIK.** *The Bell System Technical Journal,* November 1969, vol. 48 (9), 2909, 2947